# FASCICULE DE BREVET EUROPEEN

(11) **EP 2 287 904 B1**
(45) Date de publication et mention de la délivrance du brevet: **27.02.2019**
(21) Numéro de dépôt: 10305877.2
(22) Date de dépôt: 10.08.2010
(51) Int. Cl.: H01L 23/485, H01L 21/60, H01L 25/065, H01L 21/98

(54) **Procédé d'assemblage de deux composants électroniques**
Verfahren zum Zusammenbau von zwei elektronischen Komponenten
Method for assembling two electronic components

(30) Priorité: 13.08.2009 FR 0955657
(43) Date de publication de la demande: 23.02.2011
(73) Titulaire: COMMISSARIAT À L'ÉNERGIE ATOMIQUE ET AUX ÉNERGIES ALTERNATIVES, 75015 Paris (FR)
(72) Inventeur: MARION, François, 38950, SAINT MARTIN LE VINOUX (FR)
(74) Mandataire: Cabinet Laurent & Charras

(56) Documents cités:
- US-A- 5 767 580
- US-A- 6 130 148
- US-A1- 2006 231 953
- US-A1- 2006 278 966

## Description

### DOMAINE DE L'INVENTION

L'invention a trait au domaine de la microélectronique, et plus particulièrement à l'assemblage de deux composants électroniques selon la technique dite de « *flip chip »* par thermo-compression.

L'invention s'applique avantageusement aux dispositifs requérant des interconnexions de motifs métalliques à très petits pas, notamment pour la fabrication d'imageurs de très grandes dimensions et à très petits pas, comme par exemple les matrices de détection hétérogènes de grande taille comprenant un grand nombre de connexions, des matrices de détection sensibles à la température et hybridées à froid, ou encore des matrices de détection sensibles aux contraintes mécaniques.

### ETAT DE LA TECHNIQUE

L'assemblage par la technique dite de « *flip chip »* par thermocompression consiste usuellement à former des billes électriquement conductrices sur une face d'un premier composant électronique et sur une face d'un second composant selon un motif de connexion prédéterminé. Le premier composant est alors reporté sur le second composant de manière à mettre en correspondance les billes respectives de soudure de ceux-ci puis l'ensemble est pressé et chauffé. Les billes mises en contact se déforment et fondent pour former des connexions électriques perpendiculaires au plan principal des composants électroniques, généralement sous la forme d'une tranche.

La miniaturisation des dispositifs électroniques a par ailleurs mené à une multiplication des connexions électriques requises par unité de surface. Ce faisant la compression d'un premier composant sur un second composant selon cette technique a nécessité une pression de compression toujours plus grande et donc une perte de contrôle de l'écrasement des billes.

Pour pallier cette difficulté, les billes ménagées sur la face de l'un des composant ont été remplacées par une protubérance de section réduite en matériau plus dure que celui constitutif des billes. Lors de compression des composants, ces protubérances cassent l'oxyde natif des billes de l'autre composant, et cela même à basse température, grâce à une section d'appui plus faible. Une réduction de la pression exercée, ou un nombre de connexions par unité de surface plus grande pour une même pression, est ainsi obtenue. Conjointement, la compression nécessite une température plus basse et un meilleur contrôle de l'écrasement des billes est obtenu. On peut par exemple se référer au document WO 2006/054005 pour plus de détails.

Quand bien même un gain appréciable au niveau de la pression soit obtenu par rapport à la première technique de *« flip-chip »,* il n'en demeure pas moins que la pression nécessaire augmente à mesure que le nombre de connexions par unité de surface augmente. De fait, cette technique de *« flip-chip »* par insertion de protubérances dures dans des billes connaît *in fine* les mêmes limitations.

Afin de réduire encore la pression nécessaire lors de la thermocompression, les protubérances, qui forment des éléments pleins, ont été remplacés par des inserts creux et ouverts. Ainsi la surface d'appui des inserts sur les billes se limite à la surface de l'ouverture. On peut avantageusement se reporter à la demande FR 08 51142 (publiée comme FR 2 928 033 A1) pour plus de détails.

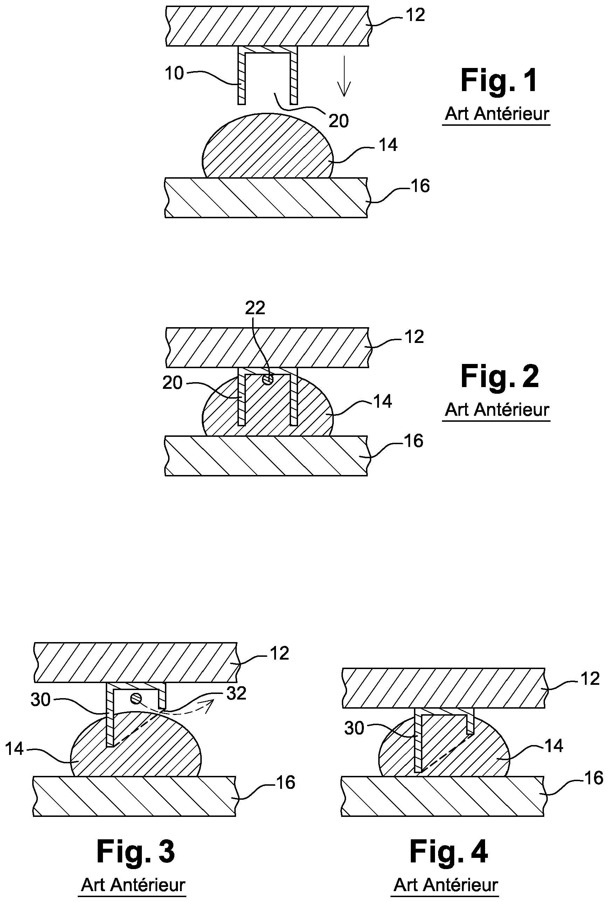

Les figures 1 et 2 illustrent un problème inhérent à ce type de technique *« flip-chip »* utilisant des inserts creux et ouverts.

Sur la figure 1, un insert creux et ouvert **10,** par exemple cylindrique, est disposé sur une face d'un premier composant électronique **12** au regard d'une bille **14** disposée sur une face d'un second composant électronique **16** et de dureté inférieure à celle de l'insert **10.** Lors de la thermocompression, l'insert **10** est inséré dans la bille **14** selon la flèche illustrée.

Une fois l'ouverture **20** de l'insert **10** introduite dans la bille **14,** il n'existe plus de passage par lequel le gaz compris dans l'insert **10** puisse s'échapper. Une fois l'insertion terminée (figure 2), le gaz emprisonné forme une bulle **22** de gaz compressé. Ce volume de gaz parasite induit des problèmes de fiabilité lors de cycles thermiques ultérieurs ainsi que des problèmes de dégazage particulièrement sensibles lorsque le dispositif électronique ainsi réalisé est destiné à fonctionner sous vide.

Pour pallier ce problème de bulle de gaz compressé, il a été conçu des inserts cylindriques biseautés, comme cela est illustré aux figures 3 et 4. L'insertion d'un tel insert **30** dans la bille **14** est alors réalisée en deux étapes. Dans une première étape, illustrée à la figure 3, l'insert biseauté **30** est partiellement inséré dans la bille **14** de manière à laisser un passage **32** de fuite des gaz. L'ensemble est alors porté sous vide de manière à évacuer le gaz présent dans l'insert **30** et l'insertion est finalisée sous vide. On peut avantageusement se reporter au document précité FR 08 51142 pour plus de détails.

Si le problème de la bulle de gaz compressé est ainsi résolu, cette technique nécessite l'utilisation d'un insert biseauté, dont la fabrication est plus complexe qu'un insert non biseauté, ainsi que la mise en oeuvre de deux étapes distinctes (pré-insertion et insertion sous vide) réduisant le rendement de fabrication de l'ensemble. En outre, cette technique nécessite l'utilisation d'une pompe à vide supplémentaire.

### EXPOSE DE L'INVENTION

Le but de la présente invention est de proposer un procédé d'assemblage de deux composants électroniques par insertion d'inserts creux et ouverts dans des éléments pleins, permettant une insertion sous atmosphère ambiante et sans création de bulle.

A cet effet, l'invention se caractérise par le fait que, lors de l'insertion d'un insert dans un élément plein convexe, au moins une surface de l'extrémité ouverte de l'insert est laissée libre de manière à créer un passage de sortie pour des gaz contenus dans l'insert.

Par « insert creux », on entend ici un motif protubérant à partir d'une surface, dont les parois latérales forment une cavité interne ouverte, et dont l'épaisseur ***e*** des parois est faible par rapport aux dimensions de l'ouverture de la cavité, de manière à définir une surface d'appui réduite lors de l'étape d'insertion de l'insert creux dans l'élément plein, et donc une force d'insertion réduite par rapport à l'insertion d'un insert plein dans un élément plein, permettant ainsi l'insertion de l'insert dans l'élément plein sous atmosphère ambiante, sans étape de thermocompression ou de refusion.

A titre d'exemple numérique, la surface ***S**'* définie par les parois de l'insert creux est inférieure d'au moins de moitié à la surface ***S*** de la section de l'insert creux (***S'**< **S***/*2*). Par exemple, dans le cas d'un insert creux tubulaire, l'épaisseur ***e*** des parois est inférieure au cinquième du diamètre externe ***D*** de l'insert (***e**<**D***/*5*). On se reportera à la demande FR 08 51142 pour un exemple de détermination de l'épaisseur ***e*** des parois de l'insert creux tubulaire par rapport à la force d'insertion de l'insert creux dans l'élément plein.

De manière privilégiée, l'insert creux est formé par un film mince refermé sur lui-même dont la section est faible par rapport à la section de l'ouverture.

En d'autres termes, une portion de l'ouverture de l'insert est latéralement décalée de l'élément plein de sorte que cette portion n'est jamais insérée dans celui-ci. Il existe ainsi un passage pour les gaz lorsque ceux-ci sont chassés de l'insert par l'élément plein lors de l'insertion.

Selon l'invention, les éléments pleins forment un motif sur une surface de l'un des composants, les inserts forment un motif sur une surface de l'autre composant et l'insertion est mise en oeuvre en décalant un motif par rapport à l'autre de manière à créer un passage de sortie des gaz pour chaque insert.

Selon des modes de réalisation particuliers de l'invention, le procédé comprend une ou plusieurs des caractéristiques suivantes, comme défini par les revendications annexées:
▪ l'extrémité ouverte de l'insert a une longueur, selon au moins un axe prédéterminé, supérieure à la longueur de l'élément plein selon ledit au moins un axe ;
▪ l'insert présente plusieurs branches prenant la forme d'une croix ou d'une étoile, les extrémités de chaque branche dépassant de l'élément plein lors de l'insertion;
▪ l'extrémité ouverte de l'insert est circulaire ;

### BREVE DESCRIPTION DES FIGURES

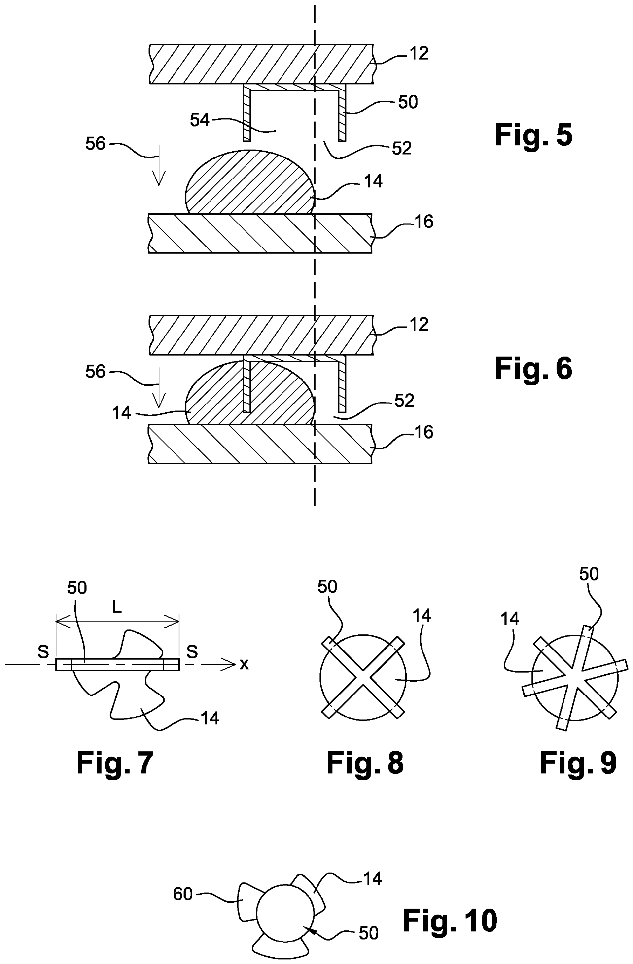

La présente invention sera mieux comprise à la lecture de la description qui va suivre, donnée uniquement à titre d'exemple, et faite en relation avec les dessins annexés, dans lesquels des références identiques désignent des éléments identiques ou analogues, et dans lesquels :
▪ les figures 1 et 2 sont des vues en section illustrant l'insertion d'un insert creux et ouverts dans une bille selon un première technique de l'état antérieur de la technique, ces figures ayant été décrites dans le préambule ;
▪ les figures 3 et 4 sont des vues en section illustrant l'insertion d'un insert creux et ouverts dans une bille selon un deuxième technique de l'état antérieur de la technique, ces figures ayant été décrites dans le préambule ;
▪ les figures 5 et 6 sont des vues en section illustrant l'insertion d'un insert creux et ouverts dans une bille selon l'invention ;
▪ les figures 7 à 10 illustrent des formes privilégiées d'inserts selon l'invention.

### DESCRIPTION DETAILLEE DE L'INVENTION

En se référant aux figures 5 et 6, lors de l'assemblage d'un premier composant électronique **12** avec un second composant électroniques **16,** chaque insert creux et ouvert **50** du premier composant **12** est disposé à l'aplomb d'un élément plein de connexion **14** du second composant **16,** par exemple une bille de soudure, de manière à ce qu'une portion **52** de l'ouverture **54** de l'insert **50** ne soit pas en regard de l'élément **14** (figure 5).

De fait, lors de l'insertion de l'insert **50** dans l'élément **14** selon la flèche **56** (figure 6), il existe toujours un passage pour le gaz contenu dans l'insert **50.** Ainsi aucune bulle ne reste emprisonnée dans ce dernier lors de l'insertion.

Selon l'invention, les motifs que forment les inserts **50** sur la face du composant **12** sont décalés par rapport au motif que forment les éléments **14** sur la face du composant **16.** Ce décalage des motifs est par exemple obtenu lors de la fabrication des composants **12** et **16** suivi de la mise en oeuvre d'un alignement classique des composants, ou bien la fabrication des inserts **50** et des éléments **14** est réalisée de manière classique et les composants **12** et **16** sont ensuite décalés lors de l'insertion.

L'invention permet notamment d'utiliser les motifs classiques de l'état de la technique, le décalage de ceux-ci assurant la création des passages de fuite pour les gaz. Ainsi, la portion 52 est par exemple de l'ordre de 1 à 2 µm, alors même que les éléments pleins de connexion 14 sont sensiblement répartis tous les 50 µm.

Dans un mode de réalisation particulier de l'invention, les dimensions et les formes des inserts sont conçues pour créer lesdits passages.

Les figures 7 à 10 sont des vues de dessus de formes privilégiées des inserts et des éléments **14.**

Dans une première forme privilégiée illustrée à la figure 7, l'insert **50** prend la forme d'une barre creuse et ouverte dont la longueur L selon un axe *x* est supérieure à la longueur de l'élément plein **14** selon ledit axe. L'élément **14** peut prendre quant à lui n'importe quelle forme. L'insert **50** dépasse ainsi de chaque côté de l'élément **50,** créant de ce fait deux passages pour les gaz.

Dans une deuxième forme privilégiée illustrée aux figures 8 et 9, l'insert **50** comporte plusieurs branches, et prend la forme par exemple d'une croix (figure 8) ou d'une étoile (figure 9), les extrémités de chaque branche dépassant de l'élément **14.** Chaque branche définit ainsi un passage pour les gaz. Le nombre de passage étant multiplié, le risque de création d'une bulle dans l'insert, en raison par exemple de défaut à la surface de l'élément **14** ou dans l'insert lui-même, est minimisé. L'élément plein **14** peut prendre une forme quelconque mais est de manière avantageuse une forme sphérique ou ellipsoïdale.

Dans une troisième forme privilégiée illustrée à la figure 10, l'insert **50** est cylindrique et l'élément plein comporte des lobes **60,** l'insert **50** étant centré, non nécessairement de manière précise, à l'endroit où les lobes **60** se rejoignent.

Bien entendu d'autres modes de réalisation, tant en formes qu'en dimensions, sont possibles dès lors qu'au moins un passage pour les gaz est présent lors de l'insertion de l'insert dans l'élément plein.

L'insert creux est avantageusement constitué d'un matériau dur, tel que notamment du W, du WSi, du TiN, du Cu, du Pt ou du Ni, recouvert par une couche de métal noble, tel que notamment du Au ou du Pt, afin d'éviter la formation d'oxyde en surface qui affaiblirait le contact électrique avec l'élément plein. L'élément plein est quant à lui de préférence constitué d'In ou d'un composite à base d'In, comme par exemple du InSb, d'un alliage à base d'étain, de plomb, d'Al ou d'un alliage d'Al, comme par exemple du AlCu.

A titre d'exemple numérique, l'insert creux est de forme tubulaire, sa section étant un disque creux, dont l'épaisseur ***e*** des parois, par exemple constituées d'un film, est égale à 0,2 micromètre et dont le diamètre externe ***D*** est de 3,6 micromètres. Dans un tel cas, la relation ***S**'<***S**/2 est remplie, ainsi que la relation ***e**<**D***/*5.*

Comme dit plus haut, l'insertion d'inserts creux dans des éléments pleins est utilisée pour réaliser un assemblage par la technique dite de « *flip chip* » dans laquelle une pluralité de connexions est formée entre un premier et un second composants électroniques. Comme cela est connu en soit, les connexions sont usuellement agencées sous la forme d'une matrice de connexions dont les connexions sont espacées d'un pas ***p*** constant.

De manière privilégiée, les dimensions des inserts creux tubulaires sont définies par rapport au pas ***p*** de la matrice de connexions. Plus particulièrement, la hauteur ***Ht*** de l'insert est égale à ***p***/4, le diamètre externe ***D*** de l'insert creux tubulaire est égal à ***p***/2,5, et l'épaisseur e des parois de l'insert creux est égale à ***D***/20 si ***p*** ≤ 10µm.

Les éléments pleins sont quant à eux de section elliptique, dont le grand axe ***Dmax*** est supérieur d'au moins 10% au diamètre externe ***D*** des inserts creux et dont le petit axe est inférieur d'au moins 10% au diamètre ***D*** afin de créer les passages de sortie des gaz.

Ainsi les valeurs numériques récapitulées dans le tableau suivant sont obtenues.

| ***p*** | ***D*** | ***e*** | **S'** | **S** | ***S*/*S'*** | ***Ht*** | ***Dmax*** |
|---|---|---|---|---|---|---|---|
| (µm) | (µm) | (µm) | (µm²) | (µm²) | | (µm) | (µm) |
| 100 | 40 | 0,4 | 50,24 | 1256 | 25 | 25 | 44 |
| 10 | 4 | 0,2 | 2,512 | 12,56 | 5 | 2,5 | 4,4 |
| 5 | 2 | 0,1 | 0,628 | 3,14 | 5 | 1,25 | 2,2 |
| 2,5 | 1 | 0,05 | 0,157 | 0,785 | 5 | 0,625 | 1,1 |

## Revendications

1. Procédé d'assemblage de deux composants électroniques (12, 16) par insertion d'inserts creux et ouverts (50) dans des éléments pleins convexes (14) de dureté inférieure à celle des inserts, chaque insert creux et ouvert (50) comportant des parois latérales formant une cavité interne ouverte dont l'épaisseur des parois est faible par rapport aux dimensions de l'ouverture de la cavité de manière à définir une surface d'appui réduite lors de l'étape d'insertion dudit insert creux et ouvert (50) dans un élément plein convexe (14), et donc une force d'insertion réduite par rapport à l'insertion d'un insert plein dans un élément plein, les inserts étant configurés pour permettre l'insertion d'inserts (50) dans des éléments pleins (14) sous atmosphère ambiante, sans étape de thermocompression ou de refusion, procédé dans lequel lors de l'insertion d'un insert (50) dans un élément plein (14), au moins une surface (52) de l'extrémité ouverte (54) de l'insert (50) est laissée libre de manière à créer un passage de sortie pour des gaz contenus dans l'insert (50), **caractérisé en ce que** les éléments pleins forment un motif sur une surface de l'un des composants, **en ce que** les inserts forment un motif sur une surface de l'autre des composants, et **en ce que** l'insertion est mise en oeuvre en décalant un motif par rapport à l'autre de manière à créer un passage de sortie des gaz pour chaque insert.

2. Procédé d'assemblage de deux composants électroniques (12, 16) selon la revendication 1, ***caractérisé* en ce que** l'extrémité ouverte de l'insert a une longueur, selon au moins un axe prédéterminé, supérieure à la longueur de l'élément plein selon ledit au moins un axe.

3. Procédé d'assemblage de deux composants électroniques (12, 16) selon la revendication 1, ***caractérisé* en ce que** l'insert présente plusieurs branches prenant la forme d'une croix ou d'une étoile, les extrémités de chaque branche dépassant de l'élément plein (14) lors de l'insertion.

4. Procédé d'assemblage de deux composants électroniques (12, 16) selon la revendication 2, ***caractérisé* en ce que** l'extrémité ouverte de l'insert est circulaire.

## Patentansprüche

1. Verfahren zum Zusammenbau von zwei elektronischen Bauteilen (12, 16) durch Einsatz von hohlen und offenen Einsätzen (50) in volle, konvexe Elemente (14) mit geringerer Härte als die Einsätze, wobei jeder hohle und offene Einsatz (50) Seitenwände umfasst, die eine innere, offene Höhlung binden, deren Wanddicke bezogen auf die Maße der Öffnung der Höhlung gering ist, so dass eine verringerte Auflagefläche beim Schritt des Einsetzens dieses hohlen und offenen Einsatzes (50) in ein volles, konvexes Element (14) und damit eine geringere Einsetzkraft bezogen auf das Einsetzen eines vollen Einsatzes in ein volles Element (14) definiert sind, wobei die Einsätze konfiguriert sind, um das Einsetzen eines Einsatzes in volle Elemente (14) bei Umgebungsatmosphäre ohne einen Schritt der Thermokompression oder des Umschmelzens zu ermöglichen; Verfahren, bei dem beim Einsetzen eines Einsatzes (50) in ein volles Element (14) mindestens eine Fläche (52) des offenen Endstücks (54) des Einsatzes (50) frei bleibt, so dass eine Auslassöffnung für im Einsatz (50) enthaltene Gase geschaffen wird, ***dadurch gekennzeichnet, dass*** die vollen Elemente ein Muster auf einer Fläche eines der Bauteile bilden und dass die Einsätze ein Muster auf einer Fläche des anderen Einsatzes bilden und dass das Einsetzen erfolgt, indem ein Muster bezogen auf das andere verschoben wird, so dass ein Gasauslass für jeden Einsatz geschaffen wird.

2. Verfahren zum Zusammenbau von zwei elektronischen Bauteilen (12, 16) nach Anspruch 1, ***dadurch gekennzeichnet, dass*** das offene Endstück des Einsatzes eine Länge nach mindestens einer vorher festgelegten Achse aufweist, die höher ist als das volle Element nach dieser mindestens einen Achse.

3. Verfahren zum Zusammenbau von zwei elektronischen Bauteilen (12, 16) nach Anspruch 1, ***dadurch gekennzeichnet, dass*** der Einsatz mehrere Arme aufweist, die die Form eines Kreuzes oder eines Sterns haben können, wobei die Endstücke jedes Arms beim Einsetzen über das volle Element (14) hinausragen.

4. Verfahren zum Zusammenbau von zwei elektronischen Bauteilen (12, 16) nach Anspruch 2, ***dadurch gekennzeichnet, dass*** das offene Endstück des Einsatzes kreisförmig ist.

## Claims

1. A method for bonding two electronic components (12, 16) by the insertion of hollow and open inserts (50) into full convex elements (14) of lower hardness than that of the inserts, each hollow and open insert (50) having side walls forming an internal open cavity, the thickness of which being small relative to the dimensions of the cavity aperture, so as to define a small seat during the step of inserting the hollow and open insert (50) into the full convex element (14), and therefore a small insertion force relative to the insertion of a full insert into a full element, the inserts being configured for allowing the insertion of inserts (50) in full elements (14) under ambient atmosphere with no thermo-compression or re-fusion step, method in which, when an insert (50) is inserted into a full element (14), at least one surface (52) of the open end (54) of the insert (50) is left free so as to create an outlet passage for gases contained in the insert (50), ***characterized*** :
▪ in that the full elements form a pattern on one surface of one of the components,
▪ in that the inserts form a pattern on one surface of the other of the components, and
▪ in that the insertion is performed by offsetting one pattern relative to the other so as to create an outlet passage for the gases in respect of each insert.

2. The method for bonding two electronic components (12, 16) as claimed in claim 1, ***characterized* in that** the open end of the insert is of greater length, along at least one predetermined axis, than the length of the full element along said at least one axis.

3. The method for bonding two electronic components (12, 16) as claimed in claim 2, ***characterized* in that** the insert has a plurality of branches assuming the shape of a cross or of a star, the end of each branch partially arranged outside the full element during the insertion.

4. The method for bonding two electronic components (12, 16) as claimed in claim 2, ***characterized* in that** the open end of the insert is circular.
